(19)

Europäisches
Patentamt
European
Patent Office
Office européen
des brevets

(11)  **EP 2 620 824 B1**

(12)  **EUROPEAN PATENT SPECIFICATION**

(45) Date of publication and mention
of the grant of the patent:
**11.09.2019  Bulletin 2019/37**

(51) Int Cl.:
*G05B 19/37* *(2006.01)*      *G03F 7/00* *(2006.01)*
*G05B 19/19* *(2006.01)*      *G05B 19/416* *(2006.01)*

(21) Application number: **12000454.4**

(22) Date of filing: **26.01.2012**

(54)  **Method for moving an object**

Verfahren zum Bewegen eines Gegenstands

Procédé pour déplacer un objet

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**31.07.2013  Bulletin 2013/31**

(73) Proprietor: **Robert Bosch GmbH
70469 Stuttgart (DE)**

(72) Inventor: **Dirks, Walrick
5641 JT Eindhoven (NL)**

(74) Representative: **Thürer, Andreas
Bosch Rexroth AG
BR/IPR
Zum Eisengiesser 1
97816 Lohr am Main (DE)**

(56) References cited:
**WO-A1-98/10340      US-A1- 2005 128 460**

- **LAMBRECHTS P ET AL: "Trajectory planning and
feedforward design for electromechanical
motion systems", CONTROL ENGINEERING
PRACTICE, PERGAMON PRESS, OXFORD, GB,
vol. 13, no. 2, 1 February 2005 (2005-02-01), pages
145-157, XP004560097, ISSN: 0967-0661, DOI:
10.1016/J.CONENGPRAC.2004.02.010**
- **HAIHUA MU ET AL: "Profile Generation Algorithm
and Implementation for High Accuracy Motion",
ROBOTICS AND BIOMIMETICS, 2006. ROBIO '06.
IEEE INTERNATIONAL CON FERENCE ON, IEEE,
PI, 1 December 2006 (2006-12-01), pages 549-554,
XP031068846, ISBN: 978-1-4244-0570-1**

**EP 2 620 824 B1**

Printed by Jouve, 75001 PARIS (FR)

**Description**

Field of the invention

The current invention relates to a method for obtaining a fourth order trajectory for moving an object from a first point to a second point over a distance by using predefined velocity, acceleration, jerk and snap constraint values, and to a corresponding device.

Prior Art

Feedforward control is a well known technique for high performance motion control problems in industry. It is widely applied in motion tasks for robots, pick-and-place units and positioning systems. Such a motion task generally includes performing a motion of an object from a position *A* to a position *B,* starting at a time *t* and covering a distance *d*. Usually, this task is performed by dedicated motion control devices (motion controllers) and typically comprises the steps of trajectory planning, feedforward control, system compensation and feedback control and further includes internal checks, diagnostics, safety issues, communication, etc.

Trajectory planning includes determining an allowable trajectory for all degrees of freedom, separately or as a multidimensional trajectory, and calculating an allowable trajectory for each actuation device. To simplify the tasks of the motion controller, usually trajectory planning and feedforward control are performed separately for each actuating device, relying on system compensation and feedback control to deal with interactions and non-linearities.

For this purpose, each actuating device is typically considered to be acting on a simple object, usually a single mass, moving along a single degree of freedom. The feedforward control problem then includes generating the force or force profile required to perform the acceleration of the mass in accordance with the desired trajectory. Conversely, the desired trajectory should be such that the required force is allowable (in the sense of mechanical load on the system) and providable by the actuating device. This approach is often referred to as "mass feedforward" or "rigid-body feedforward".

Planners for second and third order trajectories are well known and many approaches for obtaining a valid solution exist. Extension to fourth order trajectory planning, however, is often problematic.

Known third order planners are based on a stepwise change of the jerk (the third derivative of the position) between 0, a maximum positive jerk constraint value, $j_{max}$, and a maximum negative jerk constraint value, $-j_{max}$. In fourth order planners, the jerk is changed gradually (i.e. linearly). As a consequence, its derivative, the so called snap (the fourth derivative of the position) is changed stepwise between 0, a maximum positive snap constraint value, $s_{max}$, and a maximum negative snap constraint value, $-s_{max}$. This shape of the fourth order point-to-point profile is necessary to obtain time-optimality, i.e. to perform the desired movement in the shortest possible time.

Fourth order trajectory planning, in contrast to third order planning, has proved its value in some high end applications, e.g. in semiconductor lithography technology. Simulations have shown that settling times are significantly reduced by using trajectories based on fourth order planning. In general, it is assumed that applications requiring extremely high positioning precision can dramatically benefit from this type of trajectory planning or setpoint generation.

An overview of higher order trajectory planning is given in Report No. DCT 2003-18 from Technische Universiteit Eindhoven, "Trajectory planning and feedforward design for electromechanical motion systems", version 2, by Paul Lambrechts (1 April 2003). The report includes a solution for a fourth order point-to-point problem. The solution, however, is not time-optimal in all cases, especially not in such cases where the distance to be covered is too small to reach maximum velocity, and thus has to be considered incomplete. US2005/128460 discloses a method and a device for obtaining a fourth order trajectory for moving a moving part of a lithographic projection apparatus.

It is therefore desirable to have at hand a method for planning a fourth order trajectory time-optimal for all movement tasks performable by a corresponding motion controller, especially for situations where known methods do not provide optimal, or at least valid solutions.

Disclosure of the Invention

According to the invention, a method for obtaining a time optimal fourth order trajectory for moving an object from a first point to a second point over a distance and by using predefined velocity, acceleration, jerk and snap constraint values according to claim 1 and a corresponding device according to claim 9 is provided.

Advantages of the Invention

For the purposes of this invention, "jerk" shall denote the third derivative and "snap" shall denote the fourth derivative of the position of an object. Correspondingly, jerk and snap profiles shall refer to representations of the jerk and snap values over time analogously to a trajectory, corresponding to a representation of the position over time.

Typically, a motion control system to which the method according to the invention is applicable comprises velocity, acceleration, jerk and snap constraint values, further referred to as $v_{max}$, $a_{max}$, $j_{max}$ and $s_{max}$. To achieve movement from a point $A$ to a point $B$ over a distance d in a minimum time (thus providing "time optimality" or a "time-optimal" solution), it is evident that the velocity of the positioned object must be increased to a maximum allowable value as fast as possible and later be decreased as fast as possible. This is realized by increasing the acceleration to a high value as fast as possible, and then decreasing it again as soon as needed to avoid velocity constraint violation or position overshoot.

A high acceleration is achieved by increasing the jerk as fast as possible, and then decreasing it again as soon as needed to avoid acceleration or velocity constraint violation or position overshoot. Finally, the jerk should be increased and decreased as fast as possible, i.e. with positive and negative snap pulses, where jerk, acceleration and velocity constraint violation, as well as position overshoot, must be avoided. In general, it can be stated that it is advantageous to have the constraint of the lowest possible derivative active at its positive or negative bound, so preferably the velocity, otherwise the acceleration, otherwise the jerk or otherwise the snap, to reach time optimality.

This time-optimal fourth order point-to-point problem may, in terms of a mathematical representation, be formulated as follows:

Determine a time $T$, and a function $x(t)$ on the interval $[0, T]$ which satisfies the initial (top line) and final (bottom line) conditions:

$$x(0) = 0 \quad \dot{x}(0) = 0 \quad \ddot{x}(0) = 0 \quad x^{(3)}(0) = 0 \quad x^{(4)}(0) = 0$$
$$x(T) = d \quad \dot{x}(T) = 0 \quad \ddot{x}(T) = 0 \quad x^{(3)}(T) = 0 \quad x^{(4)}(T) = 0'$$

and which further satisfies the constraints:

$$|\dot{x}(t)| \leq v_{max} \quad \text{for } 0 \leq t \leq T,$$
$$|\ddot{x}(t)| \leq a_{max} \quad \text{for } 0 \leq t \leq T,$$
$$|x^{(3)}(t)| \leq j_{max} \quad \text{for } 0 \leq t \leq T,$$
$$|x^{(4)}(t)| \leq s_{max} \quad \text{for } 0 \leq t \leq T,$$

in a way that $T$ is as small as possible.

In the following, the distance d is assumed to be positive. However, the invention may equally be useful for negative distances, wherein $x$ would be replaced by $-x$. It is also assumed that $v_{max}$, $a_{max}$, $j_{max}$ and $s_{max}$, are positive. Otherwise no solution exists.

According to the invention, a time-optimal method for obtaining a fourth order trajectory includes determining a first snap profile (also referred to as "TYPE1" profile) on the basis of the distance d to be covered, and of the velocity, acceleration, jerk and snap constraint values.

If the first snap profile determined does not provide the time optimal solution because a maximum velocity is not reached, a second snap profile (also referred to as "TYPE2" profile) different from the first snap profile is determined on the basis of the distance d and of the acceleration, jerk and snap constraint values. Otherwise the first snap profile represents the time optimal solution to be used for the movement task.

If the maximum velocity in the velocity profile corresponding to the second snap profile thus determined does not exceed the velocity constraint value, $v_{max}$, the second snap profile in turn represents the time optimal solution. If this is also not the case, a third snap profile (also referred to as "TYPE3" profile) is determined on the basis of the distance d, of the maximum velocity in the second velocity profile and of the velocity, acceleration, jerk and snap constraint values.

According to the invention, the snap profiles exhibit common features as specified in claims 2 to 5. Features specific to the first, second and third profiles are specified in claims 6, 7 and 8, respectively.

In particular, the motion profile generated according to the invention is highly advantageous in high-performance systems. By application of a feedforward on the basis of the fourth derivative of the position, performance can be further improved. Time-optimality, achieved with the invention, reduces the duration of the profile time up to about 7% with respect to known solutions using identical constraints on the derivatives of the position (velocity, acceleration, jerk and snap). Finally, this also results in reduction in cycle time of machines and increased productivity.

Further advantages and embodiments of the invention will become apparent from the description and the appended figures.

It should be noted that the previously mentioned features and the features to be further described in the following are usable not only in the respectively indicated combination(s), but also in further combinations or taken alone, without departing from the scope of the present invention.

In the drawings:

Figure 1    shows trajectory, velocity, acceleration, jerk and snap profiles obtainable according to the prior art,

Figure 2    shows trajectory, velocity, acceleration, jerk and snap profiles obtainable according to an embodiment of the invention,

Figure 3    shows trajectory, velocity, acceleration, jerk and snap profiles obtainable according to an embodiment of the invention, and

Figure 4    shows a comparison between the solution according to an embodiment of the present invention and the solution as known from prior art.

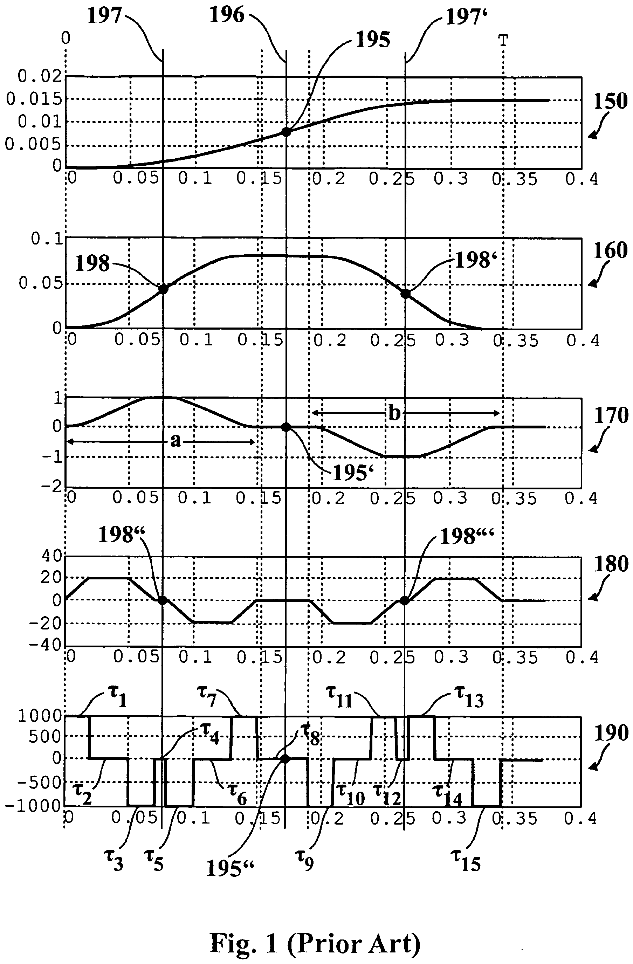

As noted above, to achieve a minimum positioning time, the velocity, and consequently the acceleration, jerk and snap values should be set to their respective maximum positive and negative values. Figure 1 shows a typical solution of a positioning problem in which all constraint values are able to be reached, and wherein $v_{max} = 0.08$ pu/s (position units per second), $a_{max} = 1$ pu/s$^2$, $j_{max} = 20$ pu/s$^3$ and $s_{max} = 1000$ pu/s$^4$. The distance to be covered is equal to $d = 0.0152$ pu. Graph 150 shows a position of an object on the y axis in pu versus a time in seconds on the x axis. Graph 150 corresponds to the trajectory for an object determined with trajectory planning according to the present invention. Movement of the object starts at zero corresponding to a start position and ends at time $T$ corresponding to an end position. Correspondingly, graphs 160, 170, 180 and 190 show a velocity (in pu/s), an acceleration (in pu/s$^2$), a jerk (in pu/s$^3$) and a snap (in pu/s$^4$) over time corresponding to the first, the second, the third and the fourth derivative of the position. The object is accelerated during a time indicated with "*a*" and decelerated during a time indicated with "*b*".

It is obvious from Figure 1 that the velocity profile is symmetric with respect to the middle of the profile represented by line 196. As a consequence, also the jerk profile is symmetric to line 196. The position, acceleration and snap profiles exhibit point symmetry with respect to points 195, 195', 195". In Figure 1, also symmetry relative to lines 197, 197' and points 198, 198', 198", 198''' can be observed, i.e. while increasing the velocity and while decreasing it again towards 0. This is typical for solutions for which the maximum velocity is attained. In the context of this application, profiles with symmetrical acceleration and deceleration will be referred to as TYPE1 profile or first profile. A TYPE1 profile is valid if the velocity reaches $v_{max}$. Otherwise, the TYPE1 profile is not time optimal. It should be understood that from prior art only TYPE1 profiles are known and/or considered in the prior art.

The shape of the TYPE1 snap profile shown in Figure 1 is, as mentioned, typical for a time-optimal solution. The profile can be split up into 15 sequential intervals, $[t_{i-1}, t_i]$ ($i = 1, 2, ..., 15$) of duration $\tau_i = t_i - t_{i-1}$.

The first, $t_1$, seventh, $t_7$, eleventh, $t_{11}$, and thirteenth, $t_{13}$, intervals of the fifteen sequential time intervals have a snap value equal to the maximum positive snap constraint value, $s_{max}$. The values corresponding to the third, $t_3$, fifth, $t_5$, ninth, $t_9$ and fifteenth, $t_{15}$ intervals of the fifteen sequential time intervals are equal to the maximum negative snap constraint value, $- s_{max}$. So, the absolute values of the latter again correspond to $s_{max}$.

The second, $t_2$, and fourteenth, $t_{14}$, intervals of the fifteen sequential time intervals have a jerk value equal to the maximum positive jerk constraint value, $j_{max}$, and the sixth, $t_6$, and fourteenth, $t_{10}$, intervals of the fifteen sequential time intervals have a jerk value equal to the maximum negative jerk constraint value, $-j_{max}$. In these four intervals the snap value equals 0.

The fourth, $t_4$, interval of the fifteen sequential time intervals has an acceleration value equal to the maximum positive acceleration constraint value, $a_{max}$, and the twelfth, $t_{12}$, interval of the fifteen sequential time intervals has an acceleration value equal to the maximum negative acceleration constraint value, $- a_{max}$. In these two intervals the jerk and the snap are both equal to 0.

The eighth, $t_8$, interval of the fifteen sequential time intervals has a velocity value equal to the maximum positive velocity constraint value, $v_{max}$. In this interval the acceleration, the jerk and the snap are equal to 0.

It is to be noted, that he evenly numbered intervals can have a duration of 0. If the duration of such an interval is 0, the corresponding constraint is typically not attained. However, any of these values is also equal to zero if the corresponding extreme value is touched, i.e. if this value is not maintainable during a certain time without the violation of other constraints or excess of the end position. In case the duration of an interval is equal to zero, the corresponding interval is not visible in the snap profile.

Because of the symmetry with respect to the middle of the profile, the following equation is valid:

$$(1) \qquad \tau_i = \tau_{16-i} \text{ for } i = 1, 2, ..., 7$$

Therefore, in the remainder of this description, the values of $\tau_i$ for $i \geq 9$ are left out of consideration but may be easily obtained by equation 1.

It can be proved and/or derived that, in the TYPE1 snap profile, the durations of the first, $t_1$, third, $t_3$, fifth, $t_5$ and seventh, $t_7$, intervals are equal ($\tau_1 = \tau_3 = \tau_5 = \tau_7$) and that the durations of the second, $t_2$ and sixth, $t_6$, intervals are equal ($\tau_2 = \tau_6$). In the context of this application, details are omitted for reasons of conciseness. To obtain a complete TYPE1 snap profile, it is thus sufficient to determine the durations of $t_1$, $t_2$, $t_4$ and $t_8$.

It can further be proved/derived that, for a TYPE1 profile, depending on the validity of equations 2 to 5, four different cases need to be considered for the calculation of $t_1$, $t_2$, $t_4$ and $t_8$. Again, details are omitted for reasons of conciseness.

$$(2) \qquad \frac{a_{max}}{j_{max}} \geq \frac{j_{max}}{s_{max}} \text{ AND } \frac{v_{max}}{a_{max}} \geq \frac{a_{max}}{j_{max}} + \frac{j_{max}}{s_{max}}$$

$$(3) \qquad \frac{a_{max}}{j_{max}} < \frac{j_{max}}{s_{max}} \text{ AND } \frac{v^2_{max}}{a^2_{max}} \geq 4\frac{a_{max}}{s_{max}}$$

$$(4) \qquad \frac{v_{max}}{j_{max}} \geq 2\frac{j^2_{max}}{s^2_{max}} \text{ AND } \frac{v_{max}}{a_{max}} < \frac{a_{max}}{j_{max}} + \frac{j_{max}}{s_{max}}$$

$$(5) \qquad \frac{v_{max}}{j_{max}} < 2\frac{j^2_{max}}{s^2_{max}} \text{ AND } \frac{v^2_{max}}{a^2_{max}} < 4\frac{a_{max}}{s_{max}}$$

In a first case, corresponding to equation 2 being valid and to all constraint values being attained, $t_1$, $t_2$ and $t_4$ are determined according to equations 6 to 8.

$$(6) \qquad \tau_1 = \frac{j_{max}}{s_{max}}$$

$$(7) \qquad \tau_2 = \frac{a_{max}}{j_{max}} - \tau_1$$

$$(8) \qquad \tau_4 = \frac{v_{max}}{a_{max}} - 2\tau_1 - \tau_2$$

In a **second case**, corresponding to equation 3 being valid and to $j_{max}$ not being attained, $t_1$, $t_2$ and $t_4$ are determined according to equations 9 to 11.

$$(9) \qquad \tau_1 = \sqrt{\frac{a_{max}}{s_{max}}}$$

$$(10) \qquad \tau_2 = 0$$

$$(11) \qquad \tau_4 = \frac{v_{max}}{a_{max}} - 2\tau_1$$

In a **third case,** corresponding to equation 4 being valid and to $a_{max}$ not being attained, $t_1$, $t_2$ and $t_4$ are determined according to equations 12 to 14.

$$(12) \quad \tau_1 = \frac{j_{max}}{s_{max}}$$

$$(13) \quad \tau_2 = -\tfrac{3}{2}\tau_1 + \sqrt{\tfrac{1}{4}\tau_1^2 + \frac{v_{max}}{j_{max}}}$$

$$(14) \quad \tau_4 = 0$$

In a **fourth case**, corresponding to equation 5 being valid and to neither $a_{max}$ nor $j_{max}$ being attained, $t_1$, $t_2$ and $t_4$ are determined according to equations 15 to 17.

$$(15) \quad \tau_1 = \sqrt[3]{\frac{v_{max}}{2s_{max}}}$$

$$(16) \quad \tau_2 = 0$$

$$(17) \quad \tau_4 = 0$$

The value for $t_8$ can finally be obtained by using the values of $t_1$, $t_2$ and $t_4$ calculated by equations 6 to 8 or 9 to 11 or 12 to 14 or 15 to 17 and the distance $d$ to be covered:

$$(18) \quad \tau_8 = (d - s_{max}\tau_1(\tau_1 + \tau_2)(2\tau_1 + \tau_2 + \tau_4)(4\tau_1 + 2\tau_2 + \tau_4))/v_{max},$$

or, in a simpler form:

$$(18a) \quad \tau_8 = \frac{d}{v_{max}} - (4\tau_1 + 2\tau_2 + \tau_4)\cdot$$

In case $t_8 = 0$, the TYPE1 profile represents the time-optimal solution and is used in a corresponding movement task. Otherwise, according to the invention, a TYPE2 profile as set forth below is determined and tested for applicability. In other words, neither the value for $a_{max}$ nor for $j_{max}$ neccessarily need to be attained, meaning $t_2$ and $t_4$ may be zero without the TYPE1 profile losing its validity. In contrast, $v_{max}$ has to be attained (but not held) for the TYPE1 profile keeping its validity. In case $v_{max}$ is not attained, and therefore $t_8 < 0$, a TYPE2 profile is to be determined to keep time optimality.

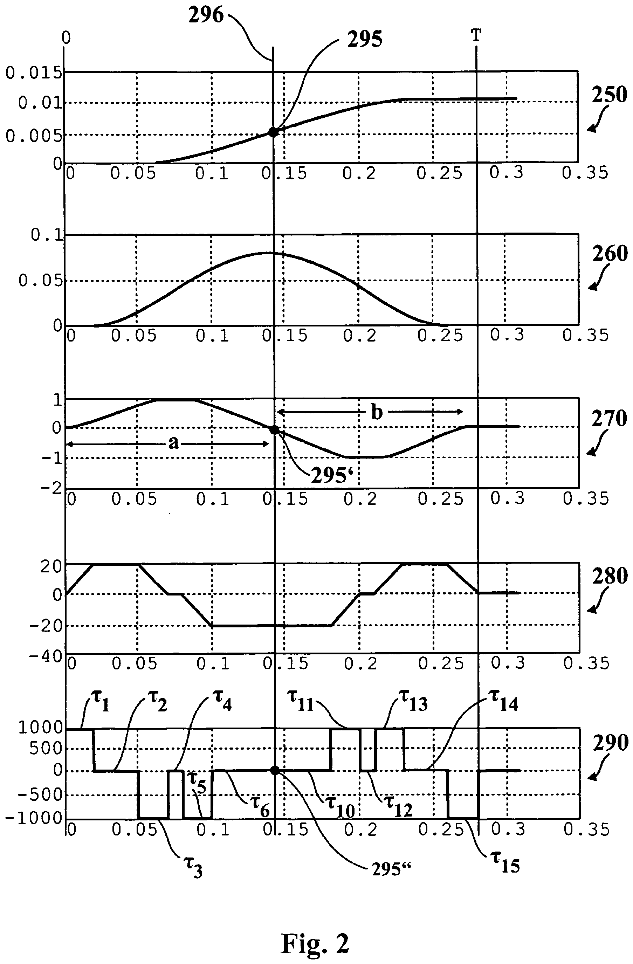

Figure 2 shows a corresponding TYPE2 or second profile obtained as solution in case $t_8 < 0$, corresponding to the case that $a_{max}$, $j_{max}$ and $s_{max}$ are attained but $v_{max}$ is not attained due to a too small distance $d$. In other words, an object which is accelerated and decelerated with maximum acceleration and deceleration values (to reach time optimality) does not reach maximum speed due to a too small distance. Graphs 250 to 290 show, corresponding to Figure 1, position, velocity, acceleration, jerk and snap values versus time. In Figure 2, elements equivalent to Figure 1 are referred to with reference numerals incremented by 100.

The duration $t_8$ is not visible in snap profile 290. Per definition, as acceleration in a TYPE2 profile is directly followed by deceleration (see a, b in Figure 2), also no $t_7$ (and, correspondingly, $t_9$) period is visible (due to a zero duration). In contrast to a TYPE1 profile, in a TYPE2 profile thus symmetry is partially lost. In the context of the invention, a TYPE2 profile is calculated as follows.

In the TYPE2 snap profile, the durations of the first, $t_1$, and third, $t_3$, intervals are equal ($\tau_1 = \tau_3$). To determine the full TYPE2 snap profile, $t_1$, $t_2$, $t_4$, $t_5$ and $t_6$ need to be calculated. For $t_1$, $t_2$, $t_5$ and $t_6$, equations 19 to 23 are valid. As one or more of $t_2$, $t_4$ and $t_6$ may be zero, eight different cases, as resulting from equations 19 to 21, need to be considered.

$$(19) \quad \tau_1 = j_{max} / s_{max} \ \text{OR} \ \tau_2 = 0$$

$$(20) \quad s_{max} \tau_1 (\tau_1 + \tau_2) = a_{max} \ \text{OR} \ \tau_4 = 0$$

$$(21) \quad \tau_5 = j_{max} / s_{max} \ \text{OR} \ \tau_6 = 0$$

$$(22) \quad \tau_1 (\tau_1 + \tau_2) = \tau_5 (\tau_6 + \tfrac{1}{2}\tau_5)$$

$$(23) \quad \begin{aligned} d &= s_{max}\tau_1(\tau_1+\tau_2)(\tau_4+\tau_5+\tau_6)^2 + s_{max}\tau_1(\tau_1+\tau_2)(2\tau_1+\tau_2)(\tau_4+\tau_5+\tau_6) + \\ &\quad + \tfrac{1}{3}s_{max}\tau_1(\tau_1+\tau_2)(\tau_1^2+(\tau_1+\tau_2)^2+\tfrac{1}{2}\tau_1(\tau_1+\tau_2)-\tau_6^2) \end{aligned}$$

From the (initially) eight cases of equations 19 to 21, the combintion $\tau_1 = j_{max} / s_{max}$ (from equation 19) and $\tau_6 = 0$ (from equation 21) cannot occur. Thus, six cases remain to be distinguished, of which three (satisfying $s_{max}\tau_1(\tau_1) + \tau_2) = a_{max}$) are handled simultaneously. Thus, four cases need to be taken into consideration.

In the **first case**, for $a_{max}$ to be attained, and therefore $t_4$ to be = 0, one of equations 24 to 26 needs to be true:

$$(24) \quad \frac{a_{max}}{j_{max}} \geq \frac{j_{max}}{s_{max}} \ \text{AND} \ \frac{d}{a_{max}} \geq \left(\frac{j_{max}}{s_{max}}\right)^2 + 3\frac{a_{max}}{s_{max}} + 2\left(\frac{a_{max}}{j_{max}}\right)^2$$

$$(25) \quad \tfrac{1}{2}\frac{j_{max}}{s_{max}} \leq \frac{a_{max}}{j} < \frac{j_{max}}{s_{max}} \ \text{AND} \ \frac{d}{a_{max}} \geq \tfrac{2}{3}\left(\frac{a_{max}}{j_{max}} + \tfrac{3}{2}\sqrt{\frac{a_{max}}{s_{max}}} + \tfrac{1}{2}\frac{j_{max}}{s_{max}}\right)^2$$

$$(26) \quad \frac{a_{max}}{j_{max}} < \tfrac{1}{2}\frac{j_{max}}{s_{max}} \ \text{AND} \ \frac{d}{a_{max}} \geq (\tfrac{17}{6} + 2\sqrt{2})\frac{a_{max}}{s_{max}}$$

These three sub-cases of equations 24 to 26 correspond to the four combinations of equations 19 and 21, of which the combination $\tau_1 = j_{max} / s_{max}$ and $\tau_6 = 0$ cannot occur. Therefore, $t_1, t_2, t_5$ and $t_6$ are easily obtained by equations 19 to 22.

It can be shown that the remaining parameter, $t_4$, can be obtained by using equation 27.

$$(27) \quad \tau_4 + \tau_5 + \tau_6 = -\tau_1 - \tfrac{1}{2}\tau_2 \pm \sqrt{D}$$

In equation 27, the variable $D$ is the discriminant of the second order equation in $\tau_4 + \tau_5 + \tau_6$, which remains after substitution of $s_{max}\tau_1(\tau_1 + \tau_2) = a_{max}$ in equation 23.

It can be written as:

$$(27a) \quad D = \frac{d}{2a_{max}} + \tfrac{1}{6}\tau_1(\tau_1 + \tau_2) - \tfrac{1}{12}\tau_2^2 + \tfrac{1}{3}\tau_6^2$$

As $t_1, t_2, t_3$ and $t_6$ are non-negative, the plus sign must be chosen in equation 27. Still, this may result in a negative value for $\tau_4$. In this case the assumption that the maximum acceleration can be attained is proven wrong and another case has to be considered.

If, in the **second case**, the maximum acceleration cannot be attained, $t_4 = 0$. According to equation 19, $\tau_1 = j_{max} / s_{max}$. This implies that also $\tau_5 = j_{max} / s_{max}$. Equation 22, in this case, simplifies to

$$(28) \quad \tau_6 = \tfrac{1}{2}\tau_1 + \tau_2 .$$

Substitution of $\tau_4 = 0$, $\tau_5 = \tau_1$ and of equation 28 in equation 23 leads to a third order equation in $\tau_2$ ($\tau_1$ is known), viz.

$$(29) \quad \frac{d}{j_{max}} = 2(\tau_1 + \tau_2)(\tfrac{3}{2}\tau_1 + \tau_2)(2\tau_1 + \tau_2) ,$$

which can be rewritten as

$$(30) \quad \tau_2^3 + 4\tfrac{1}{2}\tau_1\tau_2^2 + 6\tfrac{1}{2}\tau_1^2\tau_2 + 3\tau_1^3 - \frac{d}{2 j_{max}} = 0 .$$

The polynomial in the left hand side of this equation is ascending for positive $\tau_2$. The solution for $\tau_2$ must be in the range [0, $\dfrac{a_{max}}{j_{max}} - \dfrac{j_{max}}{s_{max}}$ ), as the maximum acceleration shall not be attained. Therefore a solution exists if this interval is not empty and if the left hand side of equation 30 is negative for $\tau_2 = 0$, and positive for $\tau_2 = \dfrac{a_{max}}{j_{max}} - \dfrac{j_{max}}{s_{max}}$. This leads to the following set of inequalities which, for this case, needs to be satisfied:

$$(31) \quad \frac{a_{max}}{j_{max}} > \frac{j_{max}}{s_{max}} \quad \textbf{AND}$$

$$\frac{d}{a_{max}} < \left(\frac{j_{max}}{s_{max}}\right)^2 + 3\frac{a_{max}}{s_{max}} + 2\left(\frac{a_{max}}{j_{max}}\right)^2 \quad \textbf{AND}$$

$$\frac{d}{j_{max}} \geq 6\left(\frac{j_{max}}{s_{max}}\right)^3$$

Equation 30 can be solved analytically or numerically according to known methods.

If, in a **third case**, no solution exists with maximum acceleration attained, nor with $\tau_1 = j_{max} / s_{max}$, it follows that $\tau_4 = 0$ and $\tau_2 = 0$. Furthermore, an extra condition exists, according to which $\tau_5 = j_{max} / s_{max}$. In this case, equation 22 can be written as

$$(32) \quad \tau_6 = \frac{\tau_1^2}{\tau_5} - \tfrac{1}{2}\tau_5 ,$$

with $\tau_1$ and $\tau_6$ as unknowns. As $\tau_6$ is non-negative, $\tau_1$ is greater than $\tfrac{1}{2}\sqrt{2}(j_{max} / s_{max})$. Substitution of $\tau_4 = 0$, $\tau_2 = 0$ and of equation 32 in equation 23 results in

$$(33) \quad \begin{aligned} d &= s_{max}(\tau_1^2(\frac{\tau_1^2}{\tau_5} + \tfrac{1}{2}\tau_5)^2 + 2\tau_1^3(\frac{\tau_1^2}{\tau_5} + \tfrac{1}{2}\tau_5) + \tfrac{5}{6}\tau_1^4 - \tfrac{1}{3}\tau_1^2(\frac{\tau_1^2}{\tau_5} - \tfrac{1}{2}\tau_5)^2) \\ &= \frac{s_{max}}{\tau_5^2}(\tfrac{2}{3}\tau_1^6 + 2\tau_5\tau_1^5 + \tfrac{13}{6}\tau_5^2\tau_1^4 + \tau_5^3\tau_1^3 + \tfrac{1}{6}\tau_5^4\tau_1^2) \end{aligned} .$$

Equation 33 is a sixth order equation in $\tau_1$. Usually, this type of equation cannot be solved analytically. However in this particular case equation 33 can be rewritten as

$$(34) \quad \begin{aligned} 0 &= \tau_1^6 + 3\tau_5\tau_1^5 + \tfrac{13}{4}\tau_5^2\tau_1^4 + \tfrac{3}{2}\tau_5^3\tau_1^3 + \tfrac{1}{4}\tau_5^4\tau_1^2 - \frac{3d\tau_5^2}{2s_{max}} \\ &= (\tau_1^3 + \tfrac{3}{2}\tau_5\tau_1^2 + \tfrac{1}{2}\tau_1^2\tau_1 + \tau_5\sqrt{\frac{3d}{2s_{max}}})(\tau_1^3 + \tfrac{3}{2}\tau_5\tau_1^2 + \tfrac{1}{2}\tau_5^2\tau_1 - \tau_5\sqrt{\frac{3d}{2s_{max}}}) \end{aligned}$$

The first factor of the right hand side of this equation is always positive for positive $\tau_1$. Therefore, the equation

$$(35) \quad \tau_1^3 + \tfrac{3}{2}\tau_5\tau_1^2 + \tfrac{1}{2}\tau_5^2\tau_1 - \tau_5\sqrt{\frac{3d}{2s_{max}}} = 0$$

needs to be solved for $\tau_1$. From equation 32 and because neither maximum acceleration nor maximum positive jerk are attained, $\tau_1$ must be in the range

$$[\tfrac{1}{2}\sqrt{2}\frac{j_{max}}{s_{max}}, \min\{\frac{j_{max}}{s_{max}}, \sqrt{\frac{a_{max}}{s_{max}}}\}).$$

Again the left hand side of equation 35 is ascending for positive $\tau_1$, so a solution exists if the polynomial evaluates to a negative value for $\tau_1 = \tfrac{1}{2}\sqrt{2}(j_{max}/s_{max})$, and to a positive value for both $\tau_1 = \frac{j_{max}}{s_{max}}$ and $\tau_1 = \sqrt{\frac{a_{max}}{s_{max}}}$. This results in the following set of inequalities for this case:

$$(36) \quad \frac{a_{max}}{j_{max}} > \tfrac{1}{2}\frac{j_{max}}{s_{max}} \text{ AND } \frac{d}{j_{max}} \geq (\tfrac{17}{24} + \tfrac{1}{2}\sqrt{2})\left(\frac{j_{max}}{s_{max}}\right)^3 \text{ AND}$$

$$\frac{d}{j_{max}} < 6\left(\frac{j_{max}}{s_{max}}\right)^3 \text{ AND } \frac{d}{a_{max}} < \tfrac{2}{3}\left(\frac{a_{max}}{j_{max}} + \tfrac{3}{2}\sqrt{\frac{a_{max}}{s_{max}}} + \tfrac{1}{2}\frac{j_{max}}{s_{max}}\right)^2$$

Under these conditions, equation 35 can be solved analytically or numerically according to known methods. Afterwards, $\tau_6$ can be obtained from equation 32.
If, in a **fourth case**, no solution exists with maximum acceleration attained, and neither with $\tau_1 = j_{max}/s_{max}$, or $\tau_5 = j_{max}/s_{max}$ one has $\tau_4 = 0$, $\tau_2 = 0$ and $\tau_6 = 0$. Equation 22 can then be written as

$$(37) \quad \tau_5 = \sqrt{2}\tau_1,$$

with $\tau_1$ and $\tau_5$ as unknowns. Apparently $\tau_1 < \tfrac{1}{2}\sqrt{2}\frac{j_{max}}{s_{max}}$ must hold. Substitution of $\tau_4 = 0$, $\tau_2 = 0$, $\tau_6 = 0$ and of equation 37 in equation 22 results in

$$(38) \quad d = s_{max}\tau_1^2(2\tau_1^2 + 2\sqrt{2}\tau_1^2 + \tfrac{5}{6}\tau_1^2) = s_{max}(\tfrac{17}{6} + 2\sqrt{2})\tau_1^4.$$

This fourth order equation is easily solved:

$$(39) \qquad \tau_1 = \sqrt[4]{\frac{d}{(\frac{17}{6} + 2\sqrt{2})s_{max}}}$$

$\tau_5$ is now determined by equation 37. From $\tau_1 < \frac{1}{2}\sqrt{2}\,\frac{j_{max}}{s_{max}}$ and $s_{max}\tau_1^2 < a_{max}$, the condition for which this solution is valid is obtained given by

$$(40) \qquad \frac{d}{j_{max}} < (\tfrac{17}{24} + \tfrac{1}{2}\sqrt{2})\left(\frac{j_{max}}{s_{max}}\right)^3 \text{ AND } \frac{d}{a_{max}} < (\tfrac{17}{6} + 2\sqrt{2})\frac{a_{max}}{s_{max}}.$$

The maximum velocity attained for the TYPE2 profile is equal to

$$(40a) \qquad v_7 = \tfrac{1}{2}s_{max}\tau_1(\tau_1 + \tau_2)(2\tau_1 + \tau_2) + a_{max}\tau_4 + \tfrac{1}{2}s_{max}\tau_5\tau_6(\tau_5 + \tau_6)^2 - \tfrac{1}{6}s_{max}\tau_5^3$$

If this value is not greater than the velocity constraint, $v_{max}$, the TYPE2 profile provides the time optimal solution. If the velocity attained exceeds the velocity constraint, $v_{max}$, according to the invention, a TYPE3 profile has to be determined.

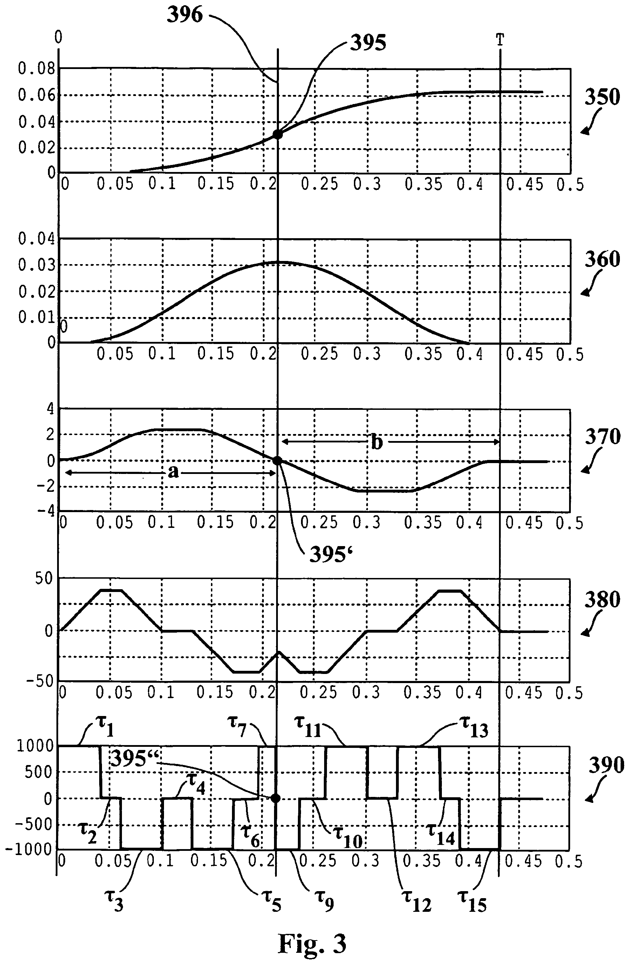

Figure 3 shows a corresponding TYPE3 or third profile obtained as solution in case the distance is too small to attain and maintain the maximum velocity in a TYPE1 profile, and $v_7$, attained with the TYPE2 profile, exceeds the velocity constraint, $v_{max}$. Graphs 350 to 390 show, similarly to Figure 1, position, velocity, acceleration, jerk and snap values versus time. In Figure 3, elements equivalent to Figure 1 are referred to with reference numerals incremented by 200.

The duration $t_8$ is not visible in snap profile 290, as it equals 0. It is typical for the TYPE3 profile that the duration of the seventh, $t_7$, (and subsequently also the ninth, $t_9$) interval are positive, but smaller than the other oddly numbered intervals. Also for the TYPE3 profile, the velocity constraint, $v_{max}$, is typically touched but not maintained.

In the TYPE3 snap profile, the durations of the first, $t_1$, and third, $t_3$, intervals are equal ($\tau_1 = \tau_3$). To determine the full TYPE3 snap profile, $t_1$, $t_2$, $t_4$, $t_5$, $t_6$ and $t_7$ need to be calculated.

For the solution of the TYPE3 profile, a set of six equations 41 to 46 for the six unknown values of $\tau_1$, $\tau_2$, $\tau_4$, $\tau_5$, $\tau_6$ and $\tau_7$ can be shown to be valid:

$$(41) \qquad \tau_1 = j_{max}/s_{max} \text{ OR } \tau_2 = 0$$

$$(42) \qquad s_{max}\tau_1(\tau_1 + \tau_2) = a_{max} \text{ OR } \tau_4 = 0$$

$$(43) \qquad \tau_5 = j_{max}/s_{max} \text{ OR } \tau_6 = 0$$

$$(44) \qquad \tau_1(\tau_1 + \tau_2) = \tau_5(\tau_6 + \tau_7) + \tfrac{1}{2}\tau_5^2 - \tfrac{1}{2}\tau_7^2$$

$$(45) \qquad \begin{aligned} d &= s_{max}\tau_1(\tau_1 + \tau_2)(\tau_4 + \tau_5 + \tau_6 + \tau_7)^2 + s_{max}\tau_1(\tau_1 + \tau_2)(2\tau_1 + \tau_2)(\tau_4 + \tau_5 + \tau_6 + \tau_7) + \\ &\quad + \tfrac{1}{3}s_{max}\tau_1(\tau_1 + \tau_2)(\tau_1^2 + (\tau_1 + \tau_2)^2 + \tfrac{1}{2}\tau_1(\tau_1 + \tau_2) - (\tau_7^2 + (\tau_6 + \tau_7)^2) - \tfrac{1}{6}s_{max}\tau_7^2(\tau_6 + \tau_7)^2 \end{aligned}$$

$$(46) \quad v_{max} = \tfrac{1}{2} s_{max} \tau_1 (\tau_1 + \tau_2)(2\tau_1 + \tau_2) + a_{max}\tau_4 + \tfrac{1}{2} s_{max}\tau_5(\tau_6 + \tau_7)(\tau_5 + \tau_6 + \tau_7) + \\ + \tfrac{1}{2} s_{max}(\tau_5{}^2 - \tau_7{}^2)(\tau_5 + \tau_6 + \tau_7) + \tfrac{1}{6} s_{max}(\tau_7{}^3 - \tau_5{}^3)$$

Basically, there are eight sets of six equations for this profile type. Solving the equations analytically is not possible anymore due to the increased complexity of the equations. Obviously, $\tau_{7,min} = 0$ is a lower bound for $\tau_7$. This value results in a maximum velocity, $v_7$, attained at $t_7$, which is greater than $v_{max}$. It can be shown that

$$\tau_{7,max} = \min\{\frac{j_{max}}{s_{max}}, \sqrt{\frac{a_{max}}{s_{max}}}, \sqrt[4]{\frac{d}{8 s_{max}}}\}$$

is an upper bound for $\tau_7$, and results in a maximum velocity, $v_7$, at $t_7$, which is less than $v_{max}$.

Therefore, the following approach is chosen:

Step 1: Take an initial value for $\tau_7$ in the range $[\tau_{7,min}, \tau_{7,max}]$.
Step 2: Solve $\tau_1$, $\tau_2$, $\tau_4$, $\tau_5$, $\tau_6$ from equations 41 to 45 with this value for $\tau_7$.
Step 3: Calculate the maximum velocity, $v_7$, based on the $\tau$-values determined.
Step 4: Update $\tau_7$ to get an improved estimate.
Step 5: Adapt $\tau_{7,min}$ or $\tau_{7,max}$ to decrease the search interval size.
Step 6: Repeat from step 2 until a sufficient accurate value for $\tau_7$ is found.

The calculation of the velocity $v_7$ in Step 3 is based on the right hand side of equation 46. The update Steps 4 and 5 are based on the secant method with safeguarding to find the new iterate in the valid range, i.e. inside the interval $[\tau_{7,min}, \tau_{7,max}]$.

In the next pages, the remaining non-trivial step (step 2) is elaborated. This concerns the solution of $\tau_1$, $\tau_2$, $\tau_4$, $\tau_5$, $\tau_6$ from equations 41 to 45 with this value for $\tau_7$. Solving this set of equations is very similar to solving equations 19 to 23 for the TYPE2 solution.

As for the TYPE2 solution, equations 41 to 45 are handled for the four cases of acceleration constraint being attained, acceleration constraint not attained and both positive and negative jerk constraint attained, neither acceleration constraint nor positive jerk constraint attained and negative jerk constraint attained, and neither maximum acceleration nor any of the jerk constraints attained.

In this context, it can be proved that $\tau_7 \le \tau_1 \le \tau_5$.

In the **first case**, maximum acceleration is attained. In that case, $\tau_1$, $\tau_2$, $\tau_5$, $\tau_6$ are determined from equations 41 to 44 (see above). Equation 45 is used to determine $\tau_4$. It is to be noted that this equation is a quadratic equation in $\tau_4 + \tau_5 + \tau_6 + \tau_7$. Knowing that $s_{max} \tau_1(\tau_1 + \tau_2) = a_{max}$, equation 45 can be rewritten as:

$$(47) \quad \tfrac{1}{2}(\tau_4 + \tau_5 + \tau_6 + \tau_7)^2 + (\tau_1 + \tfrac{1}{2}\tau_2)(\tau_4 + \tau_5 + \tau_6 + \tau_7) + \\ + \tfrac{1}{6}(\tau_1^2 + (\tau_1 + \tau_2)^2 + \tfrac{1}{2}\tau_1(\tau_1 + \tau_2) - \tau_7^2 - (\tau_6 + \tau_7)^2) - \frac{d + \tfrac{1}{6} s_{max}\tau_7^2(\tau_6 + \tau_7)^2}{2 a_{max}} = 0$$

The discriminant, $D$, of this quadratic equation equals

$$(48) \quad \begin{aligned} D &= (\tau_1 + \tfrac{1}{2}\tau_2)^2 + \frac{d + \tfrac{1}{6}s_{max}\tau_7^2(\tau_6 + \tau_7)^2}{a_{max}} + \\ &\quad - \tfrac{1}{3}(\tau_1^2 + (\tau_1 + \tau_2)^2 + \tfrac{1}{2}\tau_1(\tau_1 + \tau_2) - \tau_7^2 - (\tau_6 + \tau_7)^2) \\ &= \frac{d + \tfrac{1}{6}s_{max}\tau_7^2(\tau_6 + \tau_7)^2}{a_{max}} + \tfrac{1}{6}\tau_1(\tau_1 + \tau_2) - \tfrac{1}{12}\tau_2^2 + \tfrac{1}{3}(\tau_7^2 + (\tau_6 + \tau_7)^2) \end{aligned} .$$

It can be shown that this discriminant is always positive. This gives the following solutions for $\tau_4 + \tau_5 + \tau_6 + \tau_7$:

$$(49) \quad \tau_4 + \tau_5 + \tau_6 + \tau_7 = -\tau_1 - \tfrac{1}{2}\tau_2 \pm \sqrt{D}$$

As $\tau_1$, $\tau_2$, $\tau_5$, $\tau_6$ are nonnegative, obviously the plus sign must be chosen in this result. Still this may result in a negative value for $\tau_4$. In that case, the assumption that the maximum acceleration can be attained is proven wrong.

As for the cases of TYPE2, inequalities can be derived in terms of the constraints. However, this approach is not straightforward in this case, as conditions get too complex and are depending on the variable $\tau_7$.

If, in the **second case**, the maximum acceleration cannot be attained and $\tau_4 = 0$. Both positive and negative

$$\tau_1 = \tau_5 = \frac{j_{\max}}{s_{\max}} \, .$$

jerk constraint are attained, i.e. Under this conditions, equation 44 simplifies to

$$(49) \quad \tau_6 = \tfrac{1}{2}\tau_1 + \tau_2 - \tau_7 + \tfrac{1}{2}\frac{\tau_7^2}{\tau_1} = \tau_2 + \tfrac{1}{2}(\frac{\tau_7}{\tau_1} - 1)^2 \, .$$

Substitution of $\tau_4 = 0$, $\tau_5 = \tau_1$ and of equation 49 in equation 45 leads to a third order equation in $\tau_2$ ($\tau_1$ is known), viz.

$$(50) \quad \frac{d}{j_{\max}} = 2\tau_2^3 + (9\tau_1 + \frac{\tau_7^2}{\tau_1})\tau_2^2 + (13\tau_1^2 + 3\tau_7^2)\tau_2 + 6\tau_1^3 + \tfrac{47}{24}\tau_7^2\tau_1 + \tfrac{1}{12}\frac{\tau_7^4}{\tau_1}(1 - \tfrac{1}{2}\frac{\tau_7^2}{\tau_1^2})$$

which can be rewritten to

$$(51) \quad \tau_2^3 + (\tfrac{9}{2}\tau_1 + \tfrac{1}{2}\frac{\tau_7^2}{\tau_1})\tau_2^2 + (\tfrac{13}{2}\tau_1^2 + \tfrac{3}{2}\tau_7^2)\tau_2 + 3\tau_1^3 + \tau_7^2\tau_1(\tfrac{47}{48} + \tfrac{1}{24}\frac{\tau_7^2}{\tau_1^2}(1 - \tfrac{1}{2}\frac{\tau_7^2}{\tau_1^2})) - \frac{d}{2j_{\max}} = 0 \quad .$$

The polynomial in the left hand side of this equation is ascending for positive $\tau_2$. The solution for $\tau_2$ must be in

the range [0, $\dfrac{a_{\max}}{j_{\max}} - \dfrac{j_{\max}}{s_{\max}}$ ), as the maximum acceleration shall not be attained. Therefore a solution exists if this interval is not empty, and if the left hand side of equation 51 is negative for $\tau_2 = 0$, and positive for $\tau_2 = \dfrac{a_{\max}}{j_{\max}} - \dfrac{j_{\max}}{s_{\max}} \, .$

Equation 51 can be solved analytically or numerically according to known methods. Subsequently, $\tau_6$ can be determined from equation 49.

If, in a **third case**, no solution exists with maximum acceleration attained, nor with $\tau_1 = j_{\max} / s_{\max}$, we have $\tau_4 = 0$ and $\tau_2 = 0$. Under the extra condition that $\tau_5 = j_{\max} / s_{\max}$, equation 44 can be written as

$$(52) \quad \tau_6 = \frac{\tau_1^2}{\tau_5} + \tfrac{1}{2}\frac{\tau_7^2}{\tau_5} - \tfrac{1}{2}\tau_5 - \tau_7 \, ,$$

with $\tau_1$ and $\tau_6$ as unknowns.

Substitution of $\tau_4 = 0$, $\tau_2 = 0$ and equation 52 in equation 45 results in

$$(53) \quad \begin{aligned} \frac{d}{s_{\max}} &= \tau_1^2[(2\tau_1 + \frac{\tau_1^2}{\tau_5} + \tfrac{1}{2}\tau_5 + \tfrac{1}{2}\frac{\tau_7^2}{\tau_5})(\frac{\tau_1^2}{\tau_5} + \tfrac{1}{2}\tau_5 + \tfrac{1}{2}\frac{\tau_7^2}{\tau_5}) + \tfrac{5}{6}\tau_1^4 - \tfrac{1}{3}\tau_7^2] - (\tfrac{1}{3}\tau_1^2 + \tfrac{1}{6}\tau_7^2)(\frac{\tau_1^2}{\tau_5} - \tfrac{1}{2}\tau_5 + \tfrac{1}{2}\frac{\tau_7^2}{\tau_5})) , \\ &= \tfrac{2}{3\tau_5^2}[\tau_1^6 + 3\tau_5\tau_1^5 + (\tfrac{13}{4}\tau_5^2 + \tfrac{3}{4}\tau_7^2)\tau_1^4 + \tfrac{3}{2}\tau_5(\tau_5^2 + \tau_7^2)\tau_1^3 + \tfrac{1}{4}\tau_5^2(\tau_5^2 + 3\tau_7^2)\tau_1^2 - \tfrac{1}{16}\tau_7^2(\tau_5^2 - \tau_7^2)^2] \end{aligned}$$

which can be rewritten as

$$(54) \quad \tau_1^6 + 3\tau_5\tau_1^5 + (\tfrac{11}{4}\tau_5^2 + \tfrac{3}{4}\tau_7^2)\tau_1^4 + \tfrac{3}{2}\tau_5(\tau_5^2 + \tau_7^2)\tau_1^3 + \tfrac{1}{4}\tau_5^2(\tau_5^2 + 3\tau_7^2)\tau_1^2 - (\frac{3d\tau_5^2}{2s_{max}} + \tfrac{1}{16}\tau_7^2(\tau_5^2 - \tau_7^2)^2) = 0 \cdot$$

This is a sixth order equation in $\tau_1$. The similar equation with $\tau_7 = 0$ (equation 34), could be solved analytically. In case of equation 54, the only way to find the proper solution is by using a numerical method.

As neither maximum positive jerk nor maximum acceleration is attained, the solution $\tau_1$ must be smaller than both $j_{max} / s_{max}$ and $\sqrt{a_{max} / s_{max}}$. In addition, the solution must be greater than or equal to $\tau_7$, and, as according to equation 44 $\tau_1^2 = \tau_5\tau_6 + \tfrac{1}{2}(\tau_5 + \tau_7)^2 - \tau_7^2 \geq \tfrac{1}{2}(\tau_5 + \tau_7)^2 - \tau_7^2$, also $\sqrt{\tfrac{1}{2}(\tau_5 + \tau_7)^2 - \tau_7^2}$ is a lower bound for $\tau_1$. So actually the desired solution must be in the range $[\max\{\tau_7, \sqrt{\tfrac{1}{2}(\tau_5 + \tau_7)^2 - \tau_7^2}\}, \min\{j_{max} / s_{max}, \sqrt{a_{max} / s_{max}}\})$. Obviously, a condition for the existence of a solution of equation 54 is that this interval is not empty.

As the left hand side of equation 54 is an ascending function of $\tau_1$ for non-negative $\tau_1$, the solution only exists if the left hand side of equation 54 is negative at the lower bound of the interval and positive at the upper bound.

Once $\tau_1$ has been solved, $\tau_6$ can be determined from equation 52.

If, in the fourth case, no solution exists with maximum acceleration attained, and neither with $\tau_1 = j_{max} / s_{max}$, or $\tau_5 = j_{max} / s_{max}$ we have $\tau_4 = 0$, $\tau_2 = 0$ and $\tau_6 = 0$. Equation 44 can then be written as

$$(55) \quad \tau_5 + \tau_7 = \sqrt{2(\tau_1^2 + \tau_7^2)},$$

with $\tau_1$ and $\tau_5$ as unknowns. Substitution of $\tau_4 = 0$, $\tau_2 = 0$, $\tau_6 = 0$ and of equation 55 in equation 45 results in

$$(56) \quad \frac{d}{s_{max}} = 2\tau_1^2(\tau_1^2 + \tau_7^2) + 2\tau_1^3\sqrt{2(\tau_1^2 + \tau_7^2)} + \tfrac{5}{6}\tau_1^4 - \tfrac{2}{3}\tau_1^2\tau_7^2 - \tfrac{1}{6}\tau_7^4.$$

To eliminate the square root in equation 56, it is rearranged and the squares of both sides of the remaining equation are taken:

$$(57) \quad 8\tau_1^6(\tau_1^2 + \tau_7^2) = (\tfrac{17}{6}\tau_1^4 + \tfrac{4}{3}\tau_1^2\tau_7^2 - (\frac{d}{s_{max}} + \tfrac{1}{6}\tau_7^4))^2$$

Further elaboration of equation 57 leads to a fourth order equation in $\tau_1^2$ (so an eighth order equation in $\tau_1$):

$$(58) \quad \tfrac{1}{36}\tau_1^8 - \tfrac{4}{9}\tau_7^2\tau_1^6 + (\tfrac{5}{6}\tau_7^4 - \tfrac{17}{3}\frac{d}{s_{max}})\tau_1^4 - \tfrac{8}{3}(\frac{d}{s_{max}} + \tfrac{1}{6}\tau_7^4)\tau_7^2\tau_1^2 + (\frac{d}{s_{max}} + \tfrac{1}{6}\tau_7^4)^2 = 0$$

This equation can also be written as

$$(59) \quad (\tfrac{1}{6}\tau_1^4 - \tfrac{4}{3}\tau_7^2\tau_1^2 + (\frac{d}{s_{max}} + \tfrac{1}{6}\tau_7^4))^2 = 6(\frac{d}{s_{max}} + \tfrac{1}{6}\tau_7^4)\tau_1^4.$$

Therefore, one can also write

$$(60) \quad \tfrac{1}{6}\tau_1^4 - \tfrac{4}{3}\tau_7^2\tau_1^2 + (\frac{d}{s_{max}} + \tfrac{1}{6}\tau_7^4) = \sigma_1\sqrt{6(\frac{d}{s_{max}} + \tfrac{1}{6}\tau_7^4)\tau_1^2},$$

where $\sigma_1$ is either + 1 or - 1. A fourth order equation in $\tau_1^2$ is thus reduced to a second order equation in $\tau_1^2$, which can also be written as

$$(61) \quad \tfrac{1}{2}\tau_1^4 - (4\tau_7^2 + 3\sigma_1\sqrt{6(\frac{d}{s_{max}} + \tfrac{1}{6}\tau_7^4)})\tau_1^2 + 3(\frac{d}{s_{max}} + \tfrac{1}{6}\tau_7^4) = 0.$$

Equation 61 is easily solved. The discriminant of this equation is

$$(62) \quad \begin{aligned} D &= [4\tau_7^2 + 3\sigma_1\sqrt{6(\frac{d}{s_{max}} + \tfrac{1}{6}\tau_7^4)}]^2 - 6(\frac{d}{s_{max}} + \tfrac{1}{6}\tau_7^4) \\ &= 16(\tfrac{3}{2}\tau_7^4 + \tfrac{3}{2}\sigma_1\tau_7^2\sqrt{6(\frac{d}{s_{max}} + \tfrac{1}{6}\tau_7^4)} + 3\frac{d}{s_{max}})) \end{aligned}$$

This leads to the solutions for $\tau_1^2$, viz.

$$(63) \quad \tau_1^2 = 4\tau_7^2 + 3\sigma_1\sqrt{6(\frac{d}{s_{max}} + \tfrac{1}{6}\tau_7^4)} + \sigma_2\sqrt{D},$$

where $\sigma_2$ is a sign ($\pm$ 1). Obviously, $\tau_1$ is the positive root of the right hand side of this equation, and subsequently $\tau_5$ can be determined from equation 55.

However, the unknown signs $\sigma_1$ and $\sigma_2$ are still to be determined. These signs have to be selected in such a way that the discriminant D of equation 62 and the solution for $\tau_1^2$ are both positive. Also only those zeros are valid which have not been introduced by squaring equation 56 to obtain equation 57.

The latter can be shown to be true, if

$$(64) \quad 3\tau_7^2 + 2\sigma_1\sqrt{6(\frac{d}{s_{max}} + \tfrac{1}{6}\tau_7^4)} + \tfrac{3}{4}\sigma_2\sqrt{D} \le 0.$$

The discriminant is positive if

$$(65) \quad \tau_7^2 + \tfrac{3}{4}\sigma_1\sqrt{6(\frac{d}{s_{max}} + \tfrac{1}{6}\tau_7^4)} \ge \tfrac{1}{4}\sqrt{6(\frac{d}{s_{max}} + \tfrac{1}{6}\tau_7^4)} \quad \text{OR}$$

$$\tau_7^2 + \tfrac{3}{4}\sigma_1\sqrt{6(\frac{d}{s_{max}} + \tfrac{1}{6}\tau_7^4)} \le -\tfrac{1}{4}\sqrt{6(\frac{d}{s_{max}} + \tfrac{1}{6}\tau_7^4)}.$$

For a positive $\sigma_1$, the (first) condition of equation 65 is always satisfied. Also, as

$$D < [4\tau_7^2 + 3\sigma_1\sqrt{6(\frac{d}{s_{\max}} + \tfrac{1}{6}\tau_7^4)}]^2,$$

a positive $\sigma_1$ results in a positive solution for $\tau_1^2$. From equation 64, it can easily be seen that a positive value for $\sigma_1$ is only possible in combination with a negative value of $\sigma_2$.

If both $\sigma_1$ and $\sigma_2$ are negative, an inequality for the square root of $D$ can be easily derived from the condition that $\tau_1^2$ is positive (equation 63) and from the inequality of equation 64:

$$(66) \quad 4\tau_7^2 - \tfrac{8}{3}\sqrt{6(\frac{d}{s_{\max}} + \tfrac{1}{6}\tau_7^4)} \leq \sqrt{D} \leq 4\tau_7^2 - 3\sqrt{6(\frac{d}{s_{\max}} + \tfrac{1}{6}\tau_7^4)}$$

This inequation can never be true. In the same way, the combination of a negative $\sigma_1$ and a positive $\sigma_2$ leads to the inequality

$$(67) \quad 4\tfrac{1}{2}\tau_7^2 + \tfrac{9}{8}\sqrt{D} \leq 3\sqrt{6(\frac{d}{s_{\max}} + \tfrac{1}{6}\tau_7^4)} \leq 4\tau_7^2 + \sqrt{D}.$$

This range is also invalid.

Thus, a unique positive solution for $\tau_1^2$ in equation 63 can be found if and only if $\sigma_1 = 1$ and $\sigma_2 = -1$ are chosen.

The solution for $\tau_1$ thus found must satisfy the conditions that maximum jerk and acceleration are not attained, and that the distance is not exceeded if $\tau_1 = \tau_5 = \tau_7$, so

$$(68) \quad s_{\max}\tau_1 < j_{\max} \quad \text{AND} \quad s_{\max}\tau_1^2 < a_{\max} \quad \text{AND} \quad 8 s_{\max}\tau_1^4 < d.$$

However, if really a TYPE3 profile is present and neither of the previous cases has been selected, this will always be the case.

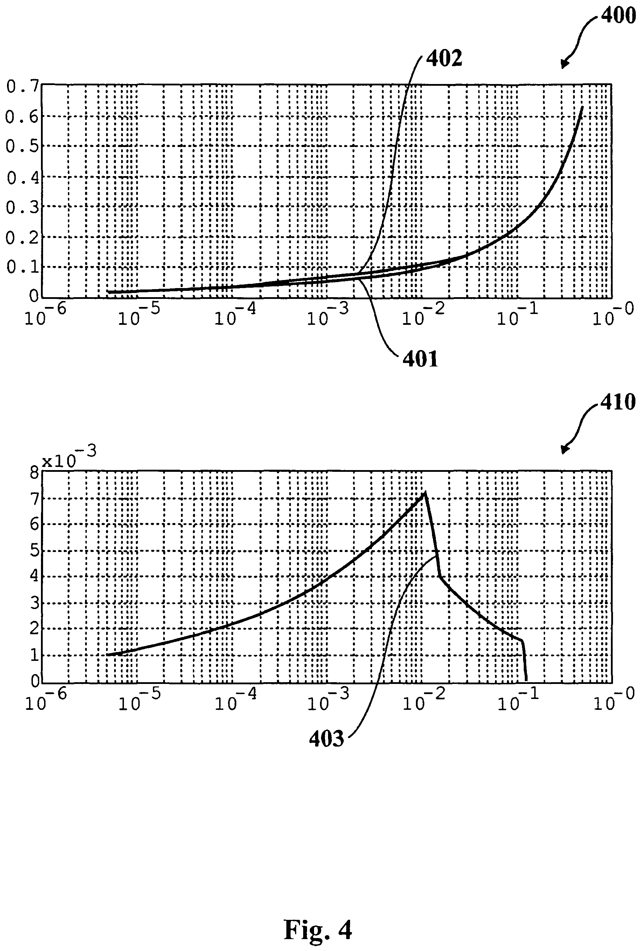

Figure 4 shows a comparison between the time-optimal solution of the fourth order point-to-point problem according to the present invention, and the solution of the point-to-point problem as known from prior art. Focus is on the duration of the profile, using both methods. In the example, fixed constraints and variable distances (step-sizes) are used. The example values used originate from a typical application. Specifically, these example values comprise a step size range of $5 \times 10^{-6}$ to $5 \times 10^{-1}$ m, a maximum velocity ($v_{\max}$) of 1 m/s, a maximum acceleration ($a_{\max}$) of 10 m/s$^2$, a maximum jerk ($j_{\max}$) of 1000 m/s$^3$ and a maximum snap of 50000 m/s$^4$.

Graph 400 of Figure 4 shows the duration of the profile on the y axis (in s) as a function of the step size on the x axis (in m), taking into account the above constraints. Line 401 shows the time-optimal solution while line 402 is the prior art solution of P. Lambrechts (see introduction) commonly used.

Graph 410 of Figure 4 shows the difference 403, actually the time gained when using time-optimal rather than the prior art profile on the y axis (in s) versus the step size on the x axis (in m). The gain in time is

$(1 - \sqrt{\tfrac{1}{2}\sqrt{3}}) \times 100\% \approx 7\%$ up to a step size of 11 mm (no constraints are attained). The slope discontinuities in this graph occur when in either of the solutions a new constraint becomes active. With step size greater than 130 mm (at step sizes larger than 130 mm, maximum velocity is attained), there is no difference in duration.

## Claims

1. A method for obtaining a fourth order trajectory (150, 250, 350) for moving an object, O, from a first point, A, to a second point, B, covering a distance, d, using predefined velocity, acceleration, jerk and snap constraint values, $v_{\max}$, $a_{\max}$, $j_{\max}$, $s_{\max}$, wherein the fourth order trajectory (150, 250, 350) is obtained on the basis of an operating snap profile (190, 290, 390) representing the fourth derivative of the trajectory (150, 250, 350) of the position of the object, O, and comprising a plurality of time intervals with corresponding snap values, and wherein

a first snap profile (190) is determined on the basis of the distance, d, and of the velocity, acceleration, jerk and snap constraint values, $v_{max}$, $a_{max}$, $j_{max}$, $s_{max}$, and is defined as the operating snap profile (190) if the velocity constraint value, $v_{max}$, is attained in a first velocity profile (160) representing the first derivative of a first trajectory (150) corresponding to the first snap profile (190), **characterized in that**

a second snap profile (290) different from the first snap profile (190) is determined on the basis of the distance, d, and of the acceleration, jerk and snap constraint values, $a_{max}$, $j_{max}$, $s_{max}$, and is defined as the operating snap profile (290) if the velocity constraint value, $v_{max}$, is not attained in the first velocity profile (160) and if a maximum velocity in a second velocity profile (260) representing the first derivative of a second trajectory (250) corresponding to the second snap profile (290) does not exceed the velocity constraint value, $v_{max}$, and a third snap profile (390) different from the first snap profile (190) and from the second snap profile (290) is determined on the basis of the distance, d, of the maximum velocity in the second velocity profile (260) and of the velocity, acceleration, jerk and snap constraint values $v_{max}$, $a_{max}$, $j_{max}$, $s_{max}$, and is defined as the operating snap profile (390) if the maximum velocity in the second velocity profile (260) does exceed the velocity constraint value, $v_{max}$.

2. Method according to claim 1, wherein the first (190), the second (290) and the third (390) snap profiles comprise fifteen time intervals ($t_1$ to $t_{15}$) with corresponding snap values in sequence, wherein at least one time interval duration may be equal to zero so that the time interval is not apparent in the snap profile.

3. Method according to claim 2, wherein the snap values corresponding to the first ($t_1$), seventh ($t_7$), eleventh ($t_{11}$) and thirteenth ($t_{13}$) intervals of the fifteen sequential time intervals, provided their duration is larger than zero, are equal to the maximum positive snap constraint value $s_{max}$,

4. Method according to claim 2 or 3, wherein the snap values corresponding to the third ($t_3$), fifth ($t_5$), ninth ($t_9$) and fifteenth ($t_{15}$) intervals of the fifteen sequential time intervals, provided their duration is larger than zero, are equal to the maximum negative snap constraint value, $-s_{max}$.

5. Method according to any one of claims 2 to 4, wherein the snap values corresponding to the second ($t_2$), fourth ($t_4$), sixth ($t_6$), eighth ($t_8$), tenth ($t_{10}$), twelfth ($t_{12}$) and fourteenth ($t_{14}$) intervals of the fifteen sequential time intervals, provided their duration is larger than zero, are zero.

6. Method according any one of claims 2 to 5, wherein in the first snap profile the durations of the first ($t_1$), third ($t_3$), fifth ($t_5$), seventh ($t_7$), ninth ($t_9$), eleventh ($t_{11}$), thirteenth ($t_{13}$) and fifteenth ($t_{15}$) intervals are equal, the durations of the second ($t_2$), sixth ($t_6$), tenth ($t_{10}$) and fourteenth ($t_{14}$) intervals are equal and possibly zero, the durations of the fourth ($t_4$) and twelfth ($t_{12}$) intervals are equal and possibly zero, and the duration of the eighth ($t_8$) interval is larger or equal to zero.

7. Method according any one of claims 2 to 6, wherein, in the second snap profile, the durations of the seventh ($t_7$), eighth ($t_8$) and ninth ($t_9$) intervals are zero, the durations of the first ($t_1$), third ($t_3$), thirteenth ($t_{13}$) and fifteenth ($t_{15}$) intervals are equal, the durations of the fifth ($t_5$) and eleventh ($t_{11}$) intervals are equal, the durations of the second ($t_2$) and fourteenth ($t_{14}$) intervals are equal and possibly zero, the durations of the fourth ($t_4$) and twelfth ($t_{12}$) intervals are equal and possibly zero and the durations of the sixth ($t_6$) and tenth ($t_{10}$) intervals are equal and possibly zero.

8. Method according any one of claims 2 to 7, wherein, in the third snap profile, the duration of the eighth ($t_8$) interval is zero, the durations of the first ($t_1$), third ($t_3$), thirteenth ($t_{13}$) and fifteenth ($t_{15}$) intervals are equal, the durations of the fifth ($t_5$) and eleventh ($t_{11}$) intervals are equal, the durations of the seventh ($t_7$) and ninth ($t_9$) intervals are equal, smaller than any one of the first ($t_1$) and fifth ($t_5$) intervals and larger than zero, the durations of the second ($t_2$) and fourteenth ($t_{14}$) intervals are equal and possibly zero, the durations of the fourth ($t_4$) and twelfth ($t_{12}$) intervals are equal and possibly zero and the durations of the sixth ($t_6$) and tenth ($t_{10}$) durations are equal or zero.

9. A device, especially a motion control device, adapted to perform the method of any one of claims 1 to 8, comprising means adapted to determine the first snap profile (190) on the basis of the distance, d, and of the velocity, acceleration, jerk and snap constraint values, $v_{max}$, $a_{max}$, $j_{max}$, $s_{max}$, means adapted to determine the second snap profile (290), different from the first snap profile (190) on the basis of the distance, d, and of the acceleration, jerk and snap constraint values, $a_{max}$, $j_{max}$, $s_{max}$, and means adapted to determine a third snap profile (390), different from the first snap profile (190) and from the second snap profile (290) on the basis of the distance, d, of the maximum velocity in the second velocity profile (260) and of the velocity, acceleration, jerk and snap constraint values, $v_{max}$, $a_{max}$, $j_{max}$, $s_{max}$.

**Patentansprüche**

1. Verfahren zum Erhalten einer Bahn vierter Ordnung (150, 250, 350) zum Bewegen eines Gegenstands, O, von einem ersten Punkt, A, zu einem zweiten Punkt, B, wobei eine Strecke, d, abgedeckt wird, mithilfe vorgegebener Geschwindigkeits-, Beschleunigungs-, Ruck-, und Snap-Abhängigkeitswerte $v_{max}$, $a_{max}$, $j_{max}$, $s_{max}$, wobei die Bahn vierter Ordnung (150, 250, 350) auf der Grundlage eines Betriebs-Snap-Profils (190, 290, 390) erhalten wird, das die vierte Ableitung der Bahn (150, 250, 350) der Position des Gegenstands, O, darstellt, und eine Mehrzahl von Zeitintervallen mit entsprechenden Snap-Werten umfasst, und wobei

ein erstes Snap-Profil (190) auf der Grundlage der Strecke, d, und der Geschwindigkeits-, Beschleunigungs-, Ruck-, und Snap-Abhängigkeitswerte, $v_{max}$, $a_{max}$, $j_{max}$, $s_{max}$, bestimmt wird und als das Betriebs-Snap-Profil (190) festgelegt wird, wenn der Geschwindigkeits-Abhängigkeitswert, $v_{max}$, in einem ersten Geschwindigkeitsprofil (160) erreicht wird, das die erste Ableitung einer ersten Bahn (150) darstellt, die dem ersten Snap-Profil (190) entspricht, **dadurch gekennzeichnet, dass**

ein zweites Snap-Profil (290), das sich von dem ersten Snap-Profil (190) unterscheidet, auf der Grundlage der Strecke, d, und der Beschleunigungs-, Ruck-, und Snap-Abhängigkeitswerte, $a_{max}$, $j_{max}$, $s_{max}$, bestimmt wird und als das Betriebs-Snap-Profil (290) festgelegt wird, wenn der Geschwindigkeits-Abhängigkeitswert, $v_{max}$, in dem ersten Geschwindigkeitsprofil (160) nicht erreicht wird und wenn eine maximale Geschwindigkeit in einem zweiten Geschwindigkeitsprofil (260), das die erste Ableitung einer zweiten Bahn (250) darstellt, die dem zweiten Snap-Profil (290) entspricht, den Geschwindigkeits-Abhängigkeitswert $v_{max}$ nicht überschreitet,

und

ein drittes Snap-Profil (390), das sich von dem ersten Snap-Profil (190) und dem zweiten Snap-Profil (290) unterscheidet, auf der Grundlage der Strecke, d, der maximalen Geschwindigkeit in dem zweiten Geschwindigkeitsprofil (260) und der Geschwindigkeits-, Beschleunigungs-, Ruck-, und Snap-Abhängigkeitswerte, $v_{max}$, $a_{max}$, $j_{max}$, $s_{max}$, bestimmt wird und als das Betriebs-Snap-Profil (390) festgelegt wird, wenn die maximale Geschwindigkeit in dem zweiten Geschwindigkeitsprofil (260) den Geschwindigkeits-Abhängigkeitswert, $v_{max}$, nicht überschreitet.

2. Verfahren nach Anspruch 1, wobei das erste (190), das zweite (290) und das dritte (390) Snap-Profil fünfzehn Zeitintervalle ($t_1$ bis $t_{15}$) mit entsprechenden fortlaufenden Snap-Werten umfasst, wobei mindestens eine Zeitintervalldauer gleich Null sein kann, so dass das Zeitintervall in dem Snap-Profil nicht sichtbar ist.

3. Verfahren nach Anspruch 2, wobei die Snap-Werte, die dem ersten ($t_1$), siebten ($t_7$), elften ($t_{11}$) und dreizehnten ($t_{13}$) Intervall der fünfzehn fortlaufenden Zeitintervalle entsprechen, sofern deren Dauer größer als Null ist, gleich dem maximalen positiven Snap-Abhängigkeitswert, $s_{max}$ sind.

4. Verfahren nach Anspruch 2 oder 3, wobei die Snap-Werte, die dem dritten ($t_3$), fünften ($t_5$), neunten ($t_9$) und fünfzehnten ($t_{15}$) Intervall der fünfzehn fortlaufenden Zeitintervalle entsprechen, sofern deren Dauer größer als Null ist, gleich dem maximalen negativen Snap-Abhängigkeitswert, $-s_{max}$, sind.

5. Verfahren nach einem der Ansprüche 2 bis 4, wobei die Snap-Werte, die dem zweiten ($t_2$), vierten ($t_4$), sechsten ($t_6$), achten ($t_8$), zehnten ($t_{10}$), zwölften ($t_{12}$) und vierzehnten ($t_{14}$) Intervall der fünfzehn fortlaufenden Zeitintervalle entsprechen, sofern deren Dauer größer als Null ist, Null sind.

6. Verfahren nach einem der Ansprüche 2 bis 5, wobei in dem ersten Snap-Profil die Dauern des ersten, ($t_1$), dritten ($t_3$), fünften ($t_5$), siebten ($t_7$), neunten ($t_9$), elften ($t_{11}$), dreizehnten ($t_{13}$) und fünfzehnten ($t_{15}$) Intervalls gleich sind, die Dauern des zweiten ($t_2$), sechsten ($t_6$), zehnten ($t_{10}$) und vierzehnten ($t_{14}$) Intervalls gleich und möglicherweise Null sind und die Dauern des vierten ($t_4$) und zwölften ($t_{12}$) Intervalls gleich und möglicherweise Null sind und die Dauer des achten ($t_8$) Intervalls größer oder gleich Null ist.

7. Verfahren nach einem der Ansprüche 2 bis 6, wobei in dem zweiten Snap-Profil die Dauern des siebten ($t_7$), achten ($t_8$) und neunten ($t_9$) Intervalls Null sind, die Dauern des ersten ($t_1$), dritten ($t_3$), dreizehnten ($t_{13}$) und fünfzehnten ($t_{15}$) Intervalls gleich sind, die Dauern des fünften ($t_5$) und elften ($t_{11}$) Intervalls gleich sind, die Dauern des zweiten ($t_2$) und vierzehnten ($t_{14}$) Intervalls gleich und möglicherweise Null sind, die Dauern des vierten ($t_4$) und zwölften ($t_{12}$) Intervalls gleich und möglicherweise Null sind und die Dauern des sechsten ($t_6$) und zehnten ($t_{10}$) Intervalls gleich und möglicherweise Null sind.

8. Verfahren nach einem der Ansprüche 2 bis 7, wobei in dem dritten Snap-Profil die Dauer des achten ($t_8$) Intervalls Null ist, die Dauern des ersten ($t_1$), dritten ($t_3$), dreizehnten ($t_{13}$) und fünfzehnten ($t_{15}$) Intervalls gleich sind, die Dauern des fünften ($t_5$) und elften ($t_{11}$) Intervalls gleich sind, die Dauern des siebten ($t_7$) und neunten ($t_9$) Intervalls

gleich, kleiner als jedes des ersten ($t_1$) und fünften ($t_5$) Intervalls und größer als Null sind, die Dauern des zweiten ($t_2$) und vierzehnten ($t_{14}$) Intervalls gleich und möglicherweise Null sind, die Dauern des vierten ($t_4$) und zwölften ($t_{12}$) Intervalls gleich und möglicherweise Null sind und die Dauern der sechsten ($t_6$) und zehnten ($t_{10}$) Dauer gleich oder Null sind.

**9.** Vorrichtung, insbesondere eine Bewegungssteuerungsvorrichtung, die geeignet ist, das Verfahren nach einem der Ansprüche 1 bis 8 durchzuführen, umfassend

Mittel, die geeignet sind, das erste Snap-Profil (190) auf der Grundlage der Strecke, d, und der Geschwindigkeits-, Beschleunigungs-, Ruck-, und Snap-Abhängigkeitswerte $v_{max}$, $a_{max}$, $j_{max}$, $s_{max}$ zu bestimmen, Mittel, die geeignet sind, das zweite Snap-Profil (290), das sich von dem ersten Snap-Profil (190) unterscheidet, auf der Grundlage der Strecke, d, und der Beschleunigungs-, Ruck-, und Snap-Abhängigkeitswerte, $a_{max}$, $j_{max}$, $s_{max}$, zu bestimmen, und Mittel, die geeignet sind, ein drittes Snap-Profil (390), das sich von dem ersten Snap-Profil (190) und dem zweiten Snap-Profil (290) unterscheidet, auf der Grundlage der Strecke, d, der maximalen Geschwindigkeit in dem zweiten Geschwindigkeitsprofil (260) und der Geschwindigkeits-, Beschleunigungs-, Ruck-, und Snap-Abhängigkeitswerte, $v_{max}$, $a_{max}$, $j_{max}$, $s_{max}$, zu bestimmen.

## Revendications

**1.** Procédé d'obtention d'une trajectoire (150, 250, 350) du quatrième ordre destinée à déplacer un objet, O, d'un premier point, A, à un deuxième point, B, en couvrant une distance, d, en utilisant des valeurs prédéfinies de contraintes de vitesse, d'accélération, de jerk et de snap, $v_{max}$, $a_{max}$, $j_{max}$, $s_{max}$, la trajectoire (150, 250, 350) du quatrième ordre étant obtenue sur la base d'un profil (190, 290, 390) de snap de fonctionnement représentant la dérivée quatrième de la trajectoire (150, 250, 350) de la position de l'objet, O, et comportant une pluralité d'intervalles de temps auxquels correspondent des valeurs de snap, et

un premier profil (190) de snap étant déterminé sur la base de la distance, d, et des valeurs de contraintes de vitesse, d'accélération, de jerk et de snap, $v_{max}$, $a_{max}$, $j_{max}$, $s_{max}$, et étant défini comme le profil (190) de snap de fonctionnement si la valeur de contrainte de vitesse, $v_{max}$, est atteinte dans un premier profil (160) de vitesse représentant la dérivée première d'une première trajectoire (150) correspondant au premier profil (190) de snap, **caractérisé**

**en ce qu'**un deuxième profil (290) de snap différent du premier profil (190) de snap est déterminé sur la base de la distance, d, et des valeurs de contraintes d'accélération, de jerk et de snap, $a_{max}$, $j_{max}$, $s_{max}$, et est défini comme le profil (290) de snap de fonctionnement si la valeur de contrainte de vitesse, $v_{max}$, n'est pas atteinte dans le premier profil (160) de vitesse et si une vitesse maximale dans un deuxième profil (260) de vitesse représentant la dérivée première d'une deuxième trajectoire (250) correspondant au deuxième profil (290) de snap ne dépasse pas la valeur de contrainte de vitesse $v_{max}$, et

**en ce qu'**un troisième profil (390) de snap différent du premier profil (190) de snap et du deuxième profil (290) de snap est déterminé sur la base de la distance, d, de la vitesse maximale dans le deuxième profil (260) de vitesse et des valeurs de contraintes de vitesse, d'accélération, de jerk et de snap, $v_{max}$, $a_{max}$, $j_{max}$, $s_{max}$, et est défini comme le profil (390) de snap de fonctionnement si la vitesse maximale dans le deuxième profil (260) de vitesse dépasse la valeur de contrainte de vitesse $v_{max}$.

**2.** Procédé selon la revendication 1, le premier (190), le deuxième (290) et le troisième (390) profils de snap comportant quinze intervalles de temps ($t_1$ à $t_{15}$) auxquels correspondent des valeurs de snap en succession, au moins une durée d'intervalle de temps pouvant être égale à zéro de telle sorte que l'intervalle de temps n'apparaisse pas dans le profil de snap.

**3.** Procédé selon la revendication 2, les valeurs de snap correspondant aux premier ($t_1$), septième ($t_7$), onzième ($t_{11}$) et treizième ($t_{13}$) intervalles parmi les quinze intervalles de temps successifs, à condition que leur durée soit supérieure à zéro, étant égales à la valeur positive maximale de contrainte de snap, $s_{max}$.

**4.** Procédé selon la revendication 2 ou 3, les valeurs de snap correspondant aux troisième ($t_3$), cinquième ($t_5$), neuvième ($t_9$) et quinzième ($t_{15}$) intervalles parmi les quinze intervalles de temps successifs, à condition que leur durée soit supérieure à zéro, étant égales à la valeur négative maximale de contrainte de snap, $-s_{max}$.

**5.** Procédé selon l'une quelconque des revendications 2 à 4, les valeurs de snap correspondant aux deuxième ($t_2$), quatrième ($t_4$), sixième ($t_6$), huitième ($t_8$), dixième ($t_{10}$), douzième ($t_{12}$) et quatorzième ($t_{14}$) intervalles parmi les quinze intervalles de temps successifs, à condition que leur durée soit supérieure à zéro, étant nulles.

6. Procédé selon l'une quelconque des revendications 2 à 5, **caractérisé en ce que**, dans le premier profil de snap, les durées des premier ($t_1$), troisième ($t_3$), cinquième ($t_5$), septième ($t_7$), neuvième ($t_9$), onzième ($t_{11}$), treizième ($t_{13}$) et quinzième ($t_{15}$) intervalles sont égales, les durées des deuxième ($t_2$), sixième ($t_6$), dixième ($t_{10}$) et quatorzième ($t_{14}$) intervalles sont égales et éventuellement nulles, les durées des quatrième ($t_4$) et douzième ($t_{12}$) intervalles sont égales et éventuellement nulles, et la durée du huitième ($t_8$) intervalle est supérieure ou égale à zéro.

7. Procédé selon l'une quelconque des revendications 2 à 6, **caractérisé en ce que**, dans le deuxième profil de snap, les durées des septième ($t_7$), huitième ($t_8$) et neuvième ($t_9$) intervalles sont nulles, les durées des premier ($t_1$), troisième ($t_3$), treizième ($t_{13}$) et quinzième ($t_{15}$) intervalles sont égales, les durées des cinquième ($t_5$) et onzième ($t_{11}$) intervalles sont égales, les durées des deuxième ($t_2$) et quatorzième ($t_{14}$) intervalles sont égales et éventuellement nulles, les durées des quatrième ($t_4$) et douzième ($t_{12}$) intervalles sont égales et éventuellement nulles et les durées des sixième ($t_8$) et dixième ($t_{10}$) intervalles sont égales et éventuellement nulles.

8. Procédé selon l'une quelconque des revendications 2 à 7, **caractérisé en ce que**, dans le troisième profil de snap, la durée du huitième intervalle ($t_8$) est nulle, les durées des premier ($t_1$), troisième ($t_3$), treizième ($t_{13}$) et quinzième ($t_{15}$) intervalles sont égales, les durées des cinquième ($t_5$) et onzième ($t_{11}$) intervalles sont égales, les durées des septième ($t_7$) et neuvième ($t_9$) intervalles sont égales, inférieures à celles de l'un quelconque des premier ($t_1$) et cinquième ($t_5$) intervalles et supérieures à zéro, les durées des deuxième ($t_2$) et quatorzième ($t_{14}$) intervalles sont égales et éventuellement nulles, les durées des quatrième ($t_4$) et douzième ($t_2$) intervalles sont égales et éventuellement nulles et les durées des sixième ($t_6$) et dixième ($t_{10}$) durées sont égales ou nulles.

9. Dispositif, en particulier un dispositif de commande de mouvement, prévu pour réaliser le procédé selon l'une quelconque des revendications 1 à 8, comportant des moyens prévus pour déterminer le premier profil (190) de snap sur la base de la distance, d, et des valeurs de contraintes de vitesse, d'accélération, de jerk et de snap, $v_{max}$, $a_{max}$, $j_{max}$, $s_{max}$, des moyens prévus pour déterminer le deuxième profil (290) de snap, différent du premier profil (190) de snap, sur la base de la distance, d, et des valeurs de contraintes d'accélération, de jerk et de snap, $a_{max}$, $j_{max}$, $s_{max}$, et des moyens prévus pour déterminer un troisième profil (390) de snap, différent du premier profil (190) de snap et du deuxième profil (290) de snap, sur la base de la distance, d, de la vitesse maximale dans le deuxième profil (260) de vitesse et des valeurs de contraintes de vitesse, d'accélération, de jerk et de snap, $v_{max}$, $a_{max}$, $j_{max}$, $s_{max}$.

**Fig. 1 (Prior Art)**

Fig. 2

**Fig. 3**

**Fig. 4**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005128460 A

**Non-patent literature cited in the description**

- **PAUL LAMBRECHTS.** Trajectory planning and feed-forward design for electromechanical motion systems. *Report No. DCT 2003-18 from Technische Universiteit Eindhoven,* 01 April 2003